# EUROPEAN PATENT APPLICATION

(11) **EP 3 101 809 A1**
(43) Date of publication of application: **07.12.2016**
(21) Application number: 14881018.7
(22) Date of filing: 31.01.2014
(51) Int. Cl.: H03K 17/16, H01L 29/739, H01L 29/78, H03K 17/687

(54) **SEMICONDUCTOR ELEMENT DRIVE APPARATUS AND POWER CONVERSION APPARATUS USING SAME**

(71) Applicant: Hitachi, Ltd., Chiyoda-ku Tokyo 100-8280 (JP)
(72) Inventor: HASHIMOTO, Takayuki, Tokyo 100-8280 (JP)
(74) Representative: Beetz & Partner mbB
(86) International application number: PCT/JP2014/052196
(87) International publication number: WO 2015/114787

(57) **Abstract**

This semiconductor element drive apparatus switches an insulating gate at a positive voltage to at a negative voltage just before recovery when an anode current is large, and holds the insulating gate at the positive voltage when the anode current is small in a semiconductor element that is provided with: a first conductivity type first semiconductor layer (n⁻ type drift layer); a second conductivity type second semiconductor layer (p type anode layer) that is adjacent to the first semiconductor layer and is exposed on one main surface (anode side); a first conductivity type third semiconductor layer (n type cathode layer) that is adjacent to the first semiconductor layer, is exposed on the other main surface (cathode side), and has an impurity concentration higher than that of the first semiconductor layer (n⁻ type drift layer); and the insulating gate on the other main surface (cathode side).

## Description

### Technical Field

The present invention relates to power conversion apparatuses, and in particular relates to a semiconductor element drive apparatus that is suitable for being widely used in various devices from small power devices such as air conditioners and microwave ovens to large power devices such as inverters used in railroads and in iron foundries, and to a power conversion apparatus using the semiconductor element drive apparatus.

### Background Art

As a related technology that reduces the conductivity loss and recovery loss of a flywheel diode, a fabric in which a MOS gate is fabricated at an anode side or a fabric in which a MOS gate is fabricated at a cathode side has been proposed (Refer to Patent Literature 1 and Patent Literature 2, for example).

In addition, as a related technology about a fabric in which a MOS gate is fabricated at the collector side of an IGBT, a technology in which attention is focused on the reduction of a switching loss has been proposed (Refer to Patent Literature 3, Patent Literature 4, and Patent Literature 5, for example).

Furthermore, a mechanism that a vibration occurs owing to the reduction of charge at a cathode side has been also known conventionally (Refer to Nonpatent Literature 1 and Nonpatent Literature 2).

### Citation List

### Patent Literature

Patent Literature 1: Japanese Unexamined Patent Application Publication No. Hei 10-163469
Patent Literature 2: Japanese Unexamined Patent Application Publication No. 2010-283132
Patent Literature 3: Japanese Unexamined Patent Application Publication No. 2001-320049
Patent Literature 4: Japanese Unexamined Patent Application Publication No. 2010-123667
Patent Literature 5: Japanese Unexamined Patent Application Publication No. 2010-251517

### Nonpatent Literature

Nonpatent Literature 1: M. Rahimo, et al., "Freewheeling Diode Reverse-Recovery Failure Modes in IGBT Application," IEEE Trans. Industry Application, vol. 37, no. 2, Mar. 2001, pp. 661-670.
Nonpatent Literature 2: K. Nakamura, et al., "Evaluation of Oscillatory Phenomena in Reverse Operation for High Voltage Diodes," Proc. IEEE ISPSD '08, May 2009, pp. 156-159.

### Summary of Invention

### Technical Problem

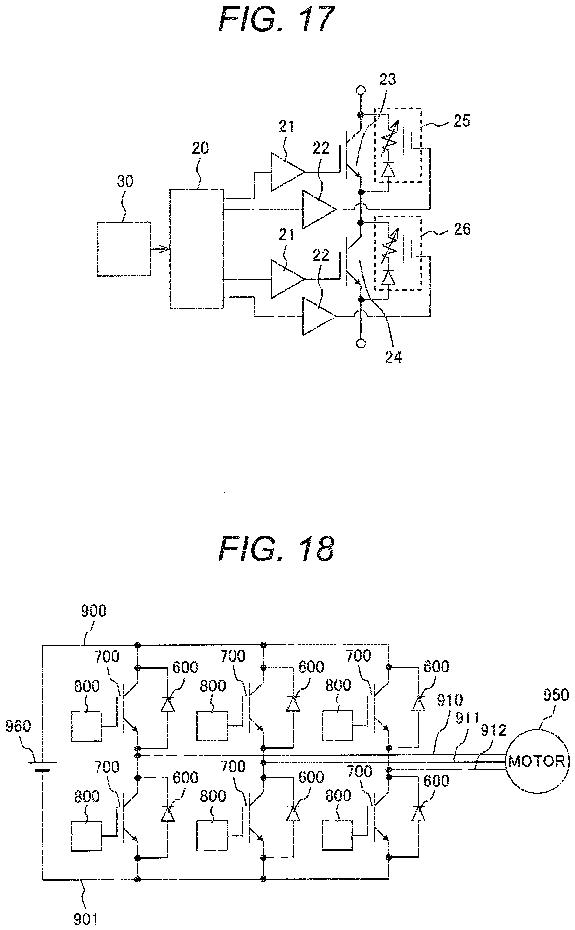

Various inverters and converters have been used for power conversion apparatuses for energy saving and renewable energy usage in recent years, and in order to realize a low-carbon society, it becomes indispensable for those to be more widely spread. Fig. 18 is a diagram showing an example of an inverter for realizing energy saving by performing variable speed control on a motor 950. Variable speed control is performed on the number of rotations of the motor 950 by converting electric energy supplied from an electric power supply 960 into an AC current with a desired frequency using IGBTs (insulated gate bipolar transistors) 700, where an IGBT is a kind of power semiconductor device. The motor 950 is a three-phase motor having a U-phase 910 input, a V-phase 911 input, and a W-phase 912 input. An input power to the U-phase 910 is supplied when the gate circuit 800 of an IGBT 700 whose collector is connected to a positive electric power supply terminal 900 (the IGBT is referred to as the upper arm IGBT hereinafter) is turned on. On the other hand, in order to stop the input power to the U-phase 910, the gate circuit 800 has only to be turned off. By repeating the above operation, electric power with a desired frequency can be supplied to the motor 950.

A flywheel diode 600 is connected to the IGBT 700 in antiparallel. The flywheel diode 600 turns a current flowing the upper arm IGBT 700 to a flywheel diode 600 connected to an IGBT 700 whose emitter is connected to a negative electric power supply terminal 901 (the IGBT is referred to as the lower arm IGBT hereinafter) when the upper arm IGBT is turned off, for example, and releases charge accumulated in the coil of the motor 950. When the upper arm IGBT 700 is turned on again, the lower arm flywheel diode 600 goes into a nonconductive state, and electric power is supplied to the motor 950 through the upper arm IGBT 700. Because the IGBT 700 and the flywheel diode 600 generate conductive losses when they are in conductive states, and switching losses when they are in switching states, it is necessary to reduce the conductivity losses and switching losses generated by the IGBT 700 and the flywheel diode 600 in order to downsize and streamline the IGBT 700 and the flywheel diode 600.

As mentioned above, technologies for reducing the conductivity loss and recovery loss of a flywheel diode are reported in Patent Literature 1 and Patent Literature 2. Although Patent Literature 1 discloses a fabric in which a MOS gate is fabricated at an anode side (Refer to Fig. 1 to Fig. 5 of Patent Literature 1) and a fabric in which a MOS gate is fabricated at a cathode side (Refer to Fig. 6 and Fig. 7 of Patent Literature 1), the present invention relates to a fabric in which a MOS gate is fabricated at a cathode side. Patent Literature 1 states that a trade-off between a forward voltage and a recovery loss can be improved because electron injection from a cathode can be controlled using a buried insulating gate.

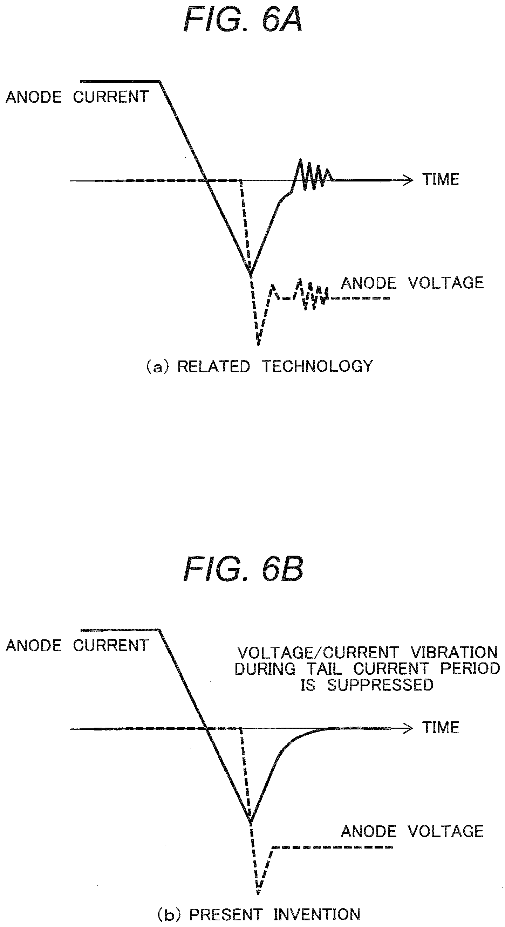

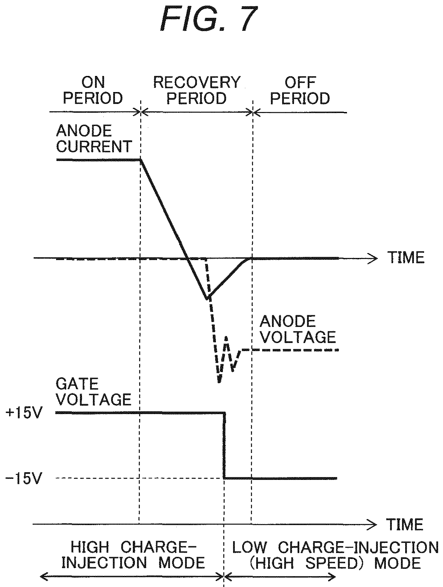

However, the inventors of this application and others found that there was the following problem in the abovementioned Patent Literature 1 and Patent Literature 2. For example, in an invention disclosed in Patent Literature 1 as an embodiment (Refer to Fig. 6 and Fig. 7 of Patent Literature 1), a forward voltage is reduced by applying a positive voltage to a gate to form an electron storage layer during the time of conduction. On the other hand, at the time of recovery, a recovery loss is reduced by setting the gate voltage zero for suppressing electron injection from a cathode.

According to an experiment made by the inventor of this application and others, it has been found that, if an anode current is small (for example, one tenth of the rated current), the anode current and an anode voltage vibrate at the time of recovery. According to the analysis of the cause of the vibration, it has been found that, because the amount of the electron injection from the cathode is reduced if the gate voltage is set zero, electrons remaining at the cathode side are abruptly reduced during the period of the tail current of the recovery, which leads to the vibrations of the voltage and current. Here, a mechanism in which the occurrence of a vibration owing to the reduction of the amount of electrons at the cathode side is described in detail in Nonpatent Literature 1 and Nonpatent Literature 2.

In order to solve the above problem, it is set as an object of the present invention to suppress the vibration of the current and the vibration of the voltage of a diode (equivalent to noises) without increasing the losses of the diode.

### Solution to Problem

In order to solve the above problem, a semiconductor element drive apparatus according to the present invention is fabricated, for example, as a semiconductor element drive apparatus for driving a semiconductor element that includes: a first conductivity type first semiconductor layer (n⁻ type drift layer); a second conductivity type second semiconductor layer (p type anode layer) that is adjacent to the first semiconductor layer and is exposed on one main surface (anode side); a first conductivity type third semiconductor layer (n type cathode layer) adjacent to the first semiconductor layer, the third semiconductor layer being exposed on the other main surface (cathode side) and having an impurity concentration higher than that of the first semiconductor layer (n⁻ type drift layer); and an insulating gate on the other main surface (cathode side). In addition, the semiconductor element drive apparatus is characterized in that it switches the insulating gate at a positive voltage to at a negative voltage just before recovery when an anode current is large, and holds the insulating gate at the positive voltage when the anode current is small.

Furthermore, a power conversion apparatus according to the present invention is, for example, a power conversion apparatus that includes: a pair of DC terminals; AC terminals the number of which is the same as that of the phases of an AC current; compositions each of which includes two parallel circuits that are serial-connected between the pair of DC terminals, each of the two parallel circuits including a switching element and a reversely-connected diode; and power conversion units the number of which is the same as the number of phases of an AC current in which the interconnection points of the parallel circuits are connected to different AC terminals respectively. Apparatuses for driving the diodes are the abovementioned semiconductor element drive apparatuses. Advantageous Effects of Invention

According to the present invention, because a diode with a low loss and a low noise can be provided, the streamlining, downsizing, and cost reduction of a semiconductor apparatus and a power conversion apparatus can be realized.

### Brief Description of Drawings

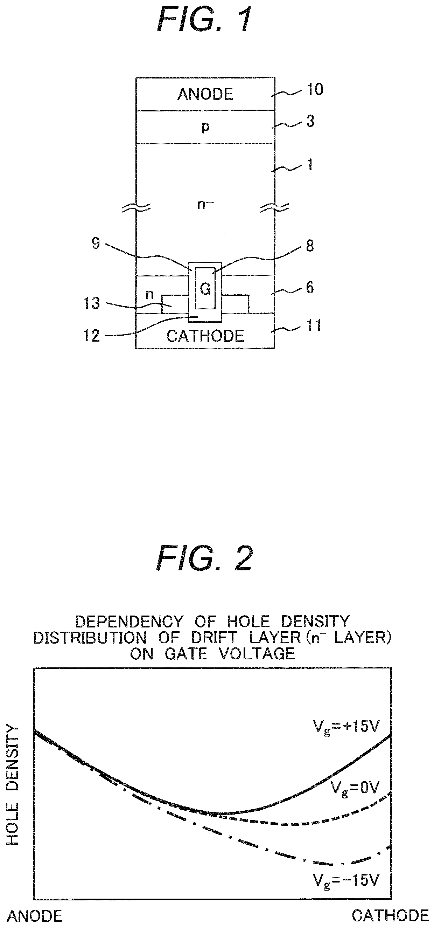

Fig. 1 is the cross-section view of a semiconductor element according to a first embodiment of the present invention.
Fig. 2 is a diagram showing the hole density distribution of the first embodiment of the present invention.

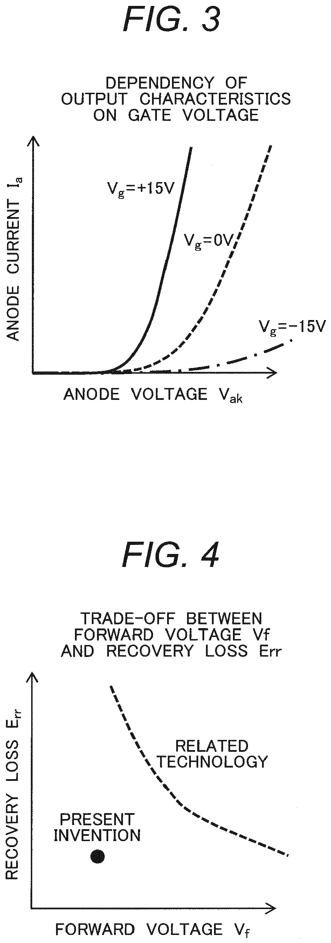

Fig. 3 is a diagram showing the output characteristics of the first embodiment of the present invention.
Fig. 4 is a diagram showing the relation between the forward voltage (Vf) and the recovery loss (Err) of the first embodiment of the present invention.

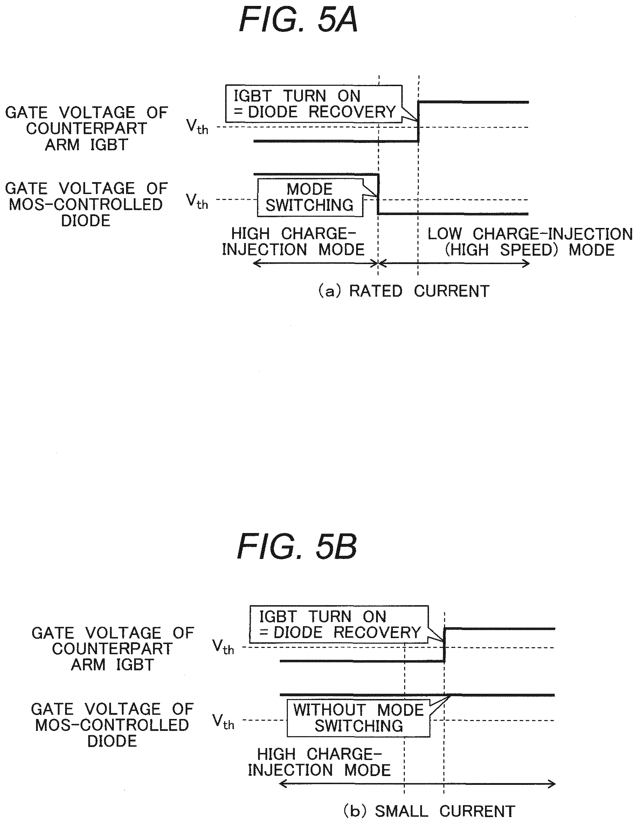

Fig. 5a is a diagram showing the gate drive sequence of a semiconductor according to the first embodiment of the present invention in the case where an anode current is equal to its rated current.
Fig. 5b is a diagram showing the gate drive sequence of the gate of a semiconductor according to the first embodiment of the present invention in the case where the anode current is a small current.
Fig. 6a is a diagram showing a recovery waveform in a related technology.
Fig. 6b is a diagram showing a recovery waveform in the present invention.
Fig. 7 is a diagram showing a recovery waveform and a gate drive sequence according to the first embodiment of the present invention.

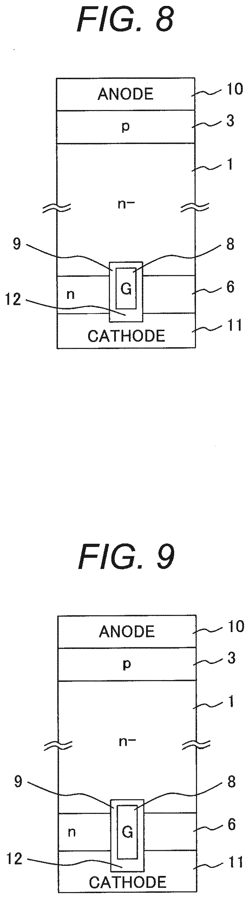

Fig. 8 is the cross-section view of a semiconductor element according to a second embodiment of the present invention.
Fig. 9 is the cross-section view of a semiconductor element according to a third embodiment of the present invention.

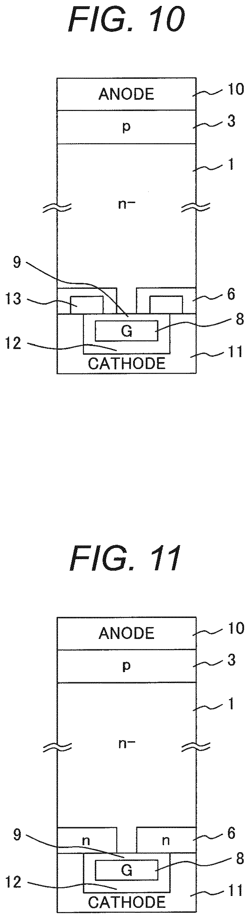

Fig. 10 is the cross-section view of a semiconductor element according to a fourth embodiment of the present invention.
Fig. 11 is the cross-section view of a semiconductor element according to a fifth embodiment of the present invention.

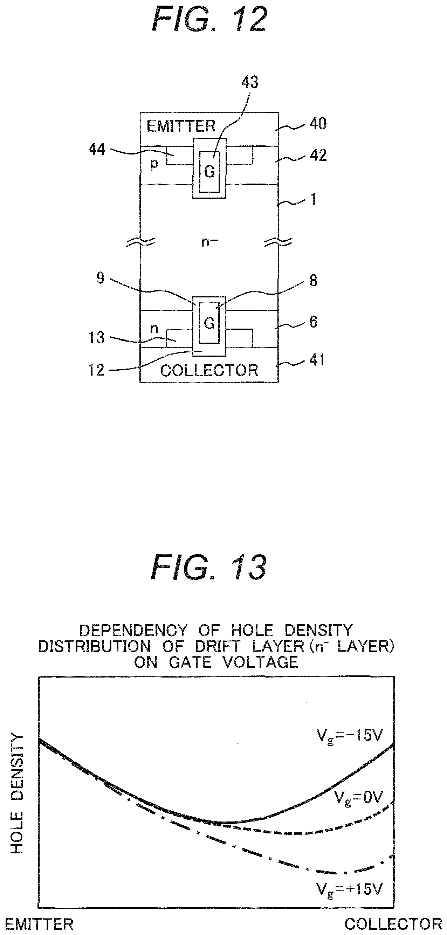

Fig. 12 is the cross-section view of a semiconductor element according to a sixth embodiment of the present invention.
Fig. 13 is a diagram showing the hole density distribution of the sixth embodiment of the present invention.

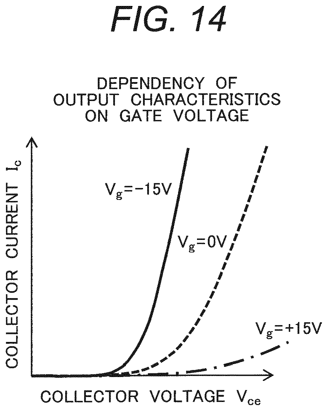

Fig. 14 is a diagram showing the output characteristics of the sixth embodiment of the present invention.

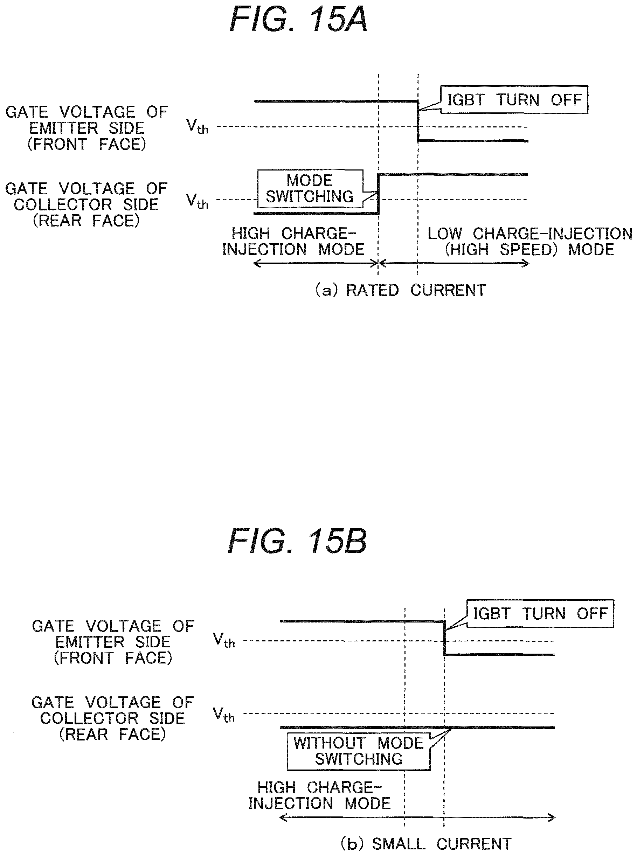

Fig. 15a is a diagram showing the gate drive sequence of a semiconductor according to the sixth embodiment of the present invention in the case where a collector current is equal to its rated current.
Fig. 15b is a diagram showing the gate drive sequence of the gate of the semiconductor according to the sixth embodiment of the present invention in the case where the collector current is a small current.

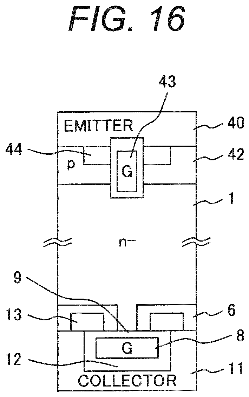

Fig. 16 is the cross-section view of a semiconductor element according to a seventh embodiment of the present invention.
Fig. 17 is a drive circuit diagram according to the present invention.
Fig. 18 is the circuit block diagram of a power conversion apparatus.

### Description of Embodiments

In the present invention, using a MOS-controlled diode in which an insulating gate is fabricated at a cathode side, the drive sequence of the insulating gate voltage is switched in accordance with the magnitude of an anode current.

Hereinafter, some examples including concrete compositions and drive methods according to the present invention will be explained in detail with reference to the accompanying drawings as several embodiments.

### First Embodiment

Hereinafter, a first embodiment of the present invention (a typical cross-section structure of the present invention and a drive method) will be explained.

Fig. 1 is the cross-section view of the first embodiment of a semiconductor element according to of the present invention. This embodiment includes: an n⁻ type drift layer 1; a p type anode layer 3; an n type cathode layer 6; a gate electrode 8; a gate insulating film 9; an anode electrode 10; a cathode electrode 11; an insulating film 12; and a p⁺ type cathode layer 13. In Fig. 1, a sign "+" shows that the relevant impurity density is high, and a sign "-" shows that the relevant impurity density is low.

The behavior of this embodiment will be briefly explained. When the semiconductor element is in a conductive state, an n type storage layer is formed at the interface between the gate electrode 8 and the n type cathode layer 6 by applying a higher voltage to the gate electrode 8 than to the cathode electrode 11, and it is suppressed that holes injected from the p type anode layer 3 is discharged into the cathode electrode 11, with the result that the forward voltage (Vf) is lowered (it means that the conductivity loss is reduced).

On the other hand, when the semiconductor element is in a recovering state, a p type inversion layer is formed at the interface between the gate electrode 8 and the n type cathode layer 6 by applying a lower voltage to the gate electrode 8 than to the cathode electrode 11, and holes injected from the p type anode layer 3 is acceleratedly discharged into the cathode electrode 11, with the result that the recovery loss is reduced.

Next, the details of the behavior of this embodiment will be explained. Fig. 2 is a diagram showing a hole density distribution between the anode and the cathode during the time of conductivity. When 0 V voltage (Vg=0 V in Fig. 2) is applied to the gate electrode, the hole density at the cathode side is reduced in comparison with when a positive voltage (Vg=+15 V in the drawing) is applied to the gate electrode. It is found that, when a negative voltage (Vg=-15 V in the drawing) is applied to the gate electrode, the hole density at the cathode side is reduced further. This is because a p type inversion layer is formed at the interface between the gate electrode 8 and the n type cathode layer 6, and holes injected from the p type anode layer 3 are discharged into the cathode electrode 11 via the p type inversion layer. If a positive voltage (+15 V in the drawing) is applied to the gate electrode, the current route via the p type inversion layer disappears, and an n type storage layer is formed, therefore the discharge of holes are suppressed and the hole density at the cathode side is increased.

In the above description, although a term "p type inversion layer" is used, it is not indispensable that the absolute value of the negative gate voltage is larger than the "threshold (absolute value)" of the n type cathode layer 6, and even if the absolute value of the negative gate voltage is smaller than the "threshold (absolute value)", because the potential of the relevant channel relative to the holes is lowered, the holes flow into the cathode electrode 11 via the channel route whose potential is lowered, therefore the discharge of the holes from the cathode is accelerated.

Fig. 3 is a diagram showing output characteristics in the case where a positive voltage, 0 V voltage, and a negative voltage are applied to the gate electrode 8. When the positive voltage is applied to the gate electrode 8, because the hole density at the cathode side is high (as shown in Fig. 2), an anode current is large (it means that the forward voltage Vf is small). When 0 V voltage is applied to the gate electrode 8, because the hole density at the cathode side is lowered, the anode current becomes small (it means that the forward voltage Vf becomes large). When the negative voltage is applied to the gate electrode 8, because the hole density at the anode side is more lowered, the anode current becomes smaller (it means that the forward voltage Vf becomes larger).

In other words, in this embodiment, it becomes possible to reduce the conductivity loss and the switching loss respectively by switching between a diode whose forward voltage (Vf) is small (that is, a diode with its recovery loss large) and a diode whose forward voltage (Vf) is large (that is, a diode with its recovery loss small) in accordance with the time axis using the gate electrode 8.

Next, advantageous effects brought about by the present invention will be explained. Fig. 4 is a diagram showing the relations between forward voltages (Vf) and recovery losses (Err). A dotted line shows the relation between the forward voltage and the recovery loss of a conventional pin diode. In the present invention, the forward voltage (Vf) and the recovery loss (Err) are respectively minimized by dynamically controlling the gate voltage in one period of switching, therefore the trade-off characteristic is improved.

As mentioned above, in examples of public knowledges (Patent Literature 1 and Patent Literature 2), the trade-off between the forward voltage (Vf) and the recovery loss is improved, and a large amount of loss reduction can be realized. However, the inventors of this application and others found that, when they examined the recovery characteristic of each of the examples of public knowledges under the condition that an anode current was small, there was a problem in that the voltage and the current vibrated. The vibrations of the voltage and the current became more remarkable at a room temperature than at a high temperature. In each of the examples of the public knowledges, because a hole density at a cathode side is reduced just before recovery in order to reduce the recovery loss, a depletion layer at the cathode side has a tendency to increase in length. Therefore, the depletion layer, which increases in length during the period of a tail current, discharges charges remaining at the cathode side, which brings about the vibrations of the voltage and the current. The details of a mechanism, in which, if the depletion layer at the cathode side has a tendency to increase in length, the vibrations of the voltage and the current occur, are described in detail in the abovementioned Nonpatent Literature 1.

In this embodiment, in order to solve this problem, the drive sequence for the gate voltage of a MOS-controlled diode is switched just before recovery in accordance with the magnitude of the anode current of the diode. Fig. 5a shows a first gate drive sequence of this embodiment in the case of the anode current being equal to the rated current, and Fig. 5b shows a first gate drive sequence of this embodiment in the case of the anode current being small. Here, although it is difficult to quantitatively define a small current, it is typically a tenth of the rated current or smaller to a half of the rated current or smaller. In the case of the anode current being equal to the rated current, the voltage applied to the gate of the MOS-controlled diode is switched from a positive voltage (a high charge-injection mode) to a negative voltage (a low charge-injection mode) just before an IGBT of the counterpart arm of the MOS-controlled diode is turned on (that is, just before the recovery of the diode), so that the recovery loss is reduced. On the other hand, in the case of the anode current being small, the voltage applied to the gate of the MOS-controlled diode is held positive (held in the high charge-injection mode), so that the hole density at the cathode side is held high.

In the present invention, although the recovery loss in the case of the anode current being small increases in comparison with the low charge-injection mode because the recovery operation is performed in the high charge-injection mode, the increase of the recovery loss in the case of the anode current being small can be neglected because it is smaller than the recovery loss in the case of the anode current being large. In other words, the merit (the vibration suppression) according to the present invention gains an advantage over the demerit (increase of the loss).

Fig. 6a and Fig. 6b are diagrams showing the waveforms of anode currents and anode voltages respectively in the case of small current recoveries. Fig. 6a shows a related drive method of the gate of a MOS-controlled diode in which a voltage applied to the gate is switched from a positive voltage (the high charge-injection mode) to a negative voltage (the low charge-injection mode), and Fig. 6b shows a drive method of the gate of a MOS-controlled diode according to the present invention in which a voltage applied to the gate is held positive (in the high charge-injection mode). In the related drive method, an anode current is abruptly reduced during the period of a tail current, and vibrations occur in the anode current and the anode voltage. On the other hand, such vibrations do not occur in the drive method according to the present invention.

Fig. 7 shows a second gate drive sequence according to the present invention. In the first gate drive sequence shown by Fig. 5a or Fig. 5b, the voltage of the gate of the MOS-controlled diode is held positive (in the high charge-injection mode) during the period of recovery, while, in Fig. 7, the voltage of the gate is switched to a negative voltage (to the low charge-injection mode) at the timing when the anode voltage decreases (that is, when the cathode voltage increases). If the negative voltage is applied to the gate electrode when the cathode voltage is high, and a p type inversion layer is formed at the interface between the gate electrode 8 and the n type cathode layer 6, holes are injected from the p+ type layer 13, therefore the vibrations of the anode current and the anode voltage are suppressed.

As described above, according to this embodiment, the losses and the vibrations (equivalent to noises) can be reduced, therefore the streamlining, downsizing, and cost reduction of a semiconductor apparatus and a power conversion apparatus using the same can be realized.

Although in this embodiment, the description have been made about a "longitudinal element", in which the cathode electrode is fabricated on the rear surface of the substrate, so far, the same advantageous effects can be also obtained in the case of a "lateral element" in which the cathode electrode is installed on the front surface of the substrate together with an anode electrode.

### Second Embodiment

Hereinafter, a second embodiment of the present invention (the cross-section structure of a semiconductor element having no p type layer at the cathode side) will be explained.

Fig. 8 is the cross-section view of a semiconductor element according to the second embodiment of the present invention. This embodiment is different from the first embodiment in that this embodiment has no p⁺ type cathode layer 13. Also in this embodiment, when the semiconductor element is in a conductive state, an n type storage layer is formed at the interface between a gate electrode 8 and an n type cathode layer 6 by applying a higher voltage to the gate electrode 8 than to a cathode electrode 11, and it is suppressed that holes injected from a p type anode layer 3 is discharged into a cathode electrode 11, with the result that a forward voltage (Vf) is lowered (it means that a conductivity loss is reduced). In addition, when the semiconductor element is in a recovering state, a p type inversion layer is formed at the interface between the gate electrode 8 and the n type cathode layer 6 by applying a lower voltage to the gate electrode 8 than to the cathode electrode 11, and holes injected from the p type anode layer 3 is acceleratedly discharged into the cathode electrode 11, with the result that a recovery loss is reduced.

Also in this embodiment, the vibrations of an anode voltage and an anode current can be suppressed by controlling the gate voltage of a MOS-controlled diode in accordance with the anode current in a similar way as shown in Fig. 5a and Fig. 5b in the case of small current recoveries.

As described above, according to this embodiment, the losses and the vibrations (equivalent to noises) can be reduced, therefore the streamlining, downsizing, and cost reduction of a semiconductor apparatus and a power conversion apparatus using the same can be realized.

### Third embodiment

Hereinafter, a third embodiment of the present invention (the cross-section structure of a semiconductor element having no p type layer at a cathode side and a gate electrode stretching to a cathode electrode side) will be explained.

Fig. 9 is the cross-section view of the semiconductor element according to the third embodiment of the present invention. This embodiment has a different point from the second embodiment in that a gate electrode 8 at a cathode electrode 11 side lies over the front surface of an n type cathode layer 6 (from a view point of to which direction the gate electrode lies, to the upper direction or to the lower direction of Fig. 9, it lies to the lower direction). With such a fabric, the gate electrode 8 covers the n type cathode layer 6 in the depth direction, therefore it becomes easier to control the potential of the n type cathode layer 6 using the gate electrode 8, which makes it possible to reduce losses and suppress vibrations.

Also in this embodiment, the vibrations of an anode voltage and an anode current can be suppressed by controlling the gate voltage of a MOS-controlled diode in accordance with the anode current in a similar way as shown in Fig. 5a and Fig. 5b in the case of small current recoveries.

As described above, according to this embodiment, the losses and the vibrations (equivalent to noises) can be reduced, therefore the streamlining, downsizing, and cost reduction of a semiconductor apparatus and a power conversion apparatus using the same can be realized.

### Fourth Embodiment

Hereinafter, a fourth embodiment of the present invention (the cross-section structure of a planar gate type semiconductor) will be explained.

Fig. 10 is the cross-section view of the semiconductor element according to the fourth embodiment of the present invention. This embodiment has a different point from the first embodiment in that a gate electrode 8 is not a trench type electrode but a planar type electrode. As is the case with the first embodiment, it is possible that losses are reduced and vibrations are suppressed in this embodiment as well.

Also in this embodiment, the vibrations of an anode voltage and an anode current can be suppressed by controlling the gate voltage of a MOS-controlled diode in accordance with the anode current in a similar way as shown in Fig. 5a and Fig. 5b in the case of small current recoveries.

As described above, according to this embodiment, the losses and the vibrations (equivalent to noises) can be reduced, therefore the streamlining, downsizing, and cost reduction of a semiconductor apparatus and a power conversion apparatus using the same can be realized.

### Fifth Embodiment

Hereinafter, a fifth embodiment of the present invention (the cross-section structure of a planar gate type semiconductor element having no p type layer at a cathode side) will be explained.

Fig. 11 is the cross-section view of the semiconductor element according to the fifth embodiment of the present invention. This embodiment is different from the fifth embodiment in that this embodiment has no p⁺ type cathode layer 13. As is the case with the fifth embodiment, it is possible that losses are reduced and vibrations are suppressed in this embodiment as well.

Also in this embodiment, the vibrations of an anode voltage and an anode current can be suppressed by controlling the gate voltage of a MOS-controlled diode in accordance with the anode current in a similar way as shown in Fig. 5a and Fig. 5b in the case of small current recoveries.

As described above, according to this embodiment, the losses and the vibrations (equivalent to noises) can be reduced, therefore the streamlining, downsizing, and cost reduction of a semiconductor apparatus and a power conversion apparatus using the same can be realized.

Hereinafter, a sixth embodiment of the present invention (the cross-section structure of an IGBT semiconductor element) will be explained.

The suppression of the vibrations of a current and a voltage regarding a diode in the case of a small current recovery regarding a diode has been discussed so far. The concept that the vibrations are suppressed by controlling a charge density in an n⁻ type drift layer 1 using a MOS gate can be applied not only to a diode but also to an IGBT. In order to suppress the vibrations of the collector voltage and collector current of an IGBT, it is necessary to fabricate a MOS gate at a collector side (rear surface) in a direction to which a depletion layer increases in length. As related technical literatures disclosing a structure in which a MOS gate is fabricated at the collector side of an IGBT, the abovementioned Patent Literature 3, Patent Literature 4, and Patent Literature 5 can be cited. However, in these literatures, attention is focused on the reduction of a switching loss, but there is no description about the reduction of a vibration. In other words, in these literatures, the MOS gate is controlled while attention is focused only on the reduction of a turnoff loss.

Fig. 12 is the cross-section view of a semiconductor element according to the sixth embodiment of the present invention. Although the structure of the collector side (rear surface) is the same as that of the cathode side (rear surface) of the first embodiment, this embodiment is different from the first embodiment in that a gate electrode 43 is fabricated at the emitter side of this embodiment. This embodiment includes: an n⁻ type drift layer 1; an n type collector layer 6; a gate electrode 8; a gate insulating film 9; an insulating film 12; p⁺ type cathode layer 13; an emitter electrode 40; a collector electrode 41; a p type channel layer 42; a gate electrode 43; and n⁺ type emitter layer 44. The gate electrode 43 controls the on/off action of the collector current, and the gate electrode 8 controls the charge distribution of the n⁻ type drift layer 1.

The behavior of this embodiment will be briefly explained. During the time of conduction (when a positive voltage is applied to the gate electrode 43 on the front surface), a p type inversion layer is formed at the interface between the gate electrode 8 and the n type collector layer 6 by applying a negative voltage to the gate electrode 8 with respect the collector electrode 41, and holes from the p+ type cathode layer 13 are acceleratedly injected, with the result that an on-voltage (Vce) is lowered (it means that a conductivity loss is reduced).

On the other hand, an n type storage layer is formed at the interface between the gate electrode 8 and the n type cathode layer 6 by applying a positive voltage to the gate electrode 8 with respect the collector electrode 41 just before the turnoff of the IGBT (that is, just before switching the voltage of the gate electrode 43 from a positive voltage to a zero volt or to a negative voltage), and the injection of holes from a p⁺ type cathode layer 13 is suppressed, with the result that a turnoff loss is reduced.

Next, the details of the behavior of this embodiment will be explained. Fig. 13 is a diagram showing the hole density distribution between the emitter and the collector during the time of conduction. When a negative voltage (Vg=-15 V in the drawing) is applied to the gate electrode, the hole density at the collector side becomes higher than when 0 V voltage (Vg=0 V in the drawing) is applied. This is because the p type inversion layer is formed at the interface between the gate electrode 8 and the n type collector layer 6 and the holes are acceleratedly injected from the p⁺ type cathode layer 13 to the n- type drift layer 1.

When a positive voltage (Vg=+15 V in the drawing) is applied to the gate electrode, the hole density at the collector side becomes lower than when 0 V voltage (Vg=0 V in the drawing) is applied. This is because the n type inversion layer is formed at the interface between the gate electrode 8 and the n type collector layer 6, and the injection of the holes from the p⁺ type cathode layer 13 is suppressed.

In the above description, although a term "p type inversion layer" is used, it is not indispensable that the absolute value of the negative gate voltage is larger than the "threshold (absolute value)" of the n type cathode layer 6, and even if the absolute value of the negative gate voltage is smaller than the "threshold (absolute value)", because the potential of the relevant channel relative to holes is lowered, the holes are injected into the n- type drift layer 1 from the p+ type cathode layer 13 via the channel route whose potential is lowered.

Fig. 14 is a diagram showing the output characteristics when the positive voltage, 0 V voltage, and the negative voltage are applied to the gate electrode 8 respectively. When the negative voltage is applied to the gate electrode 8, because the hole density at the collector side is high (as shown in Fig. 13), the collector current is large (it means that the on-voltage is small). When 0 V voltage is applied to the gate electrode 8, because the hole density at the collector side is lowered, the collector current becomes small (it means that the on-voltage becomes large). When the positive voltage is applied to the gate electrode 8, because the hole density at the collector side is much more lowered, the collector current becomes smaller (it means that the on-voltage becomes larger).

In other words, in this embodiment, it becomes possible to reduce the conductivity loss and the turnoff loss respectively by switching between an IGBT whose on-voltage is small (that is, the IGBT with its turnoff loss large) and an IGBT whose on-voltage is large (that is, the IGBT with its turnoff loss small) in accordance with the time axis using the gate electrode 8.

Fig. 15a and Fig. 15b are diagrams showing the gate drive sequences of this embodiment. Fig. 15a is a diagram showing the gate drive sequence in the case where the collector current is equal to its rated current, and Fig. 15b is a diagram showing the gate drive sequence in the case where the collector current is a small current. Here, although it is difficult to quantitatively define a small current, it is typically a tenth of the rated current or smaller to a half of the rated current or smaller. In the case of the collector current being equal to the rated current, the voltage applied to the gate at the collector side (rear surface) is switched to a positive voltage just before the gate voltage at the emitter side (front surface) is turned off (that is, just before the collector current of the IGBT is turned off) to switch from the high charge-injection mode to the low charge-injection (high speed) mode), so that the turnoff loss is reduced. On the other hand, in the case of the collector current being small, the voltage applied to the gate at the collector side (rear surface) is held negative (held in the high charge-injection mode), so that the hole density at the collector side is held high to suppress the vibrations.

As described above, according to this embodiment, the losses and the vibrations (equivalent to noises) can be reduced, therefore the streamlining, downsizing, and cost reduction of a semiconductor apparatus and a power conversion apparatus using the same can be realized.

### Seventh Embodiment

Hereinafter, a seventh embodiment of the present invention (the cross-section structure of a rear surface planar gate type IGBT semiconductor element) will be explained.

Fig. 16 is the cross-section view of the semiconductor element according to the seventh embodiment of the present invention. This embodiment has a different point from the sixth embodiment in that a gate electrode 8 is not a trench type electrode but a planar type electrode. As is the case with the sixth embodiment, it is possible that losses are reduced and vibrations are suppressed in this embodiment as well.

Also in this embodiment, the vibrations of a collector voltage and a collector current can be suppressed by controlling the gate voltage at the collector side (rear surface) in accordance with the collector current in a similar way as shown in Fig. 15a and Fig. 15b at the time of the small current turnoff of the IGBT.

As described above, according to this embodiment, the losses and the vibrations (equivalent to noises) can be reduced, therefore the streamlining, downsizing, and cost reduction of a semiconductor apparatus and a power conversion apparatus using the same can be realized. Eighth Embodiment

Next, an eighth embodiment of the present invention (diode drive circuit) will be explained.

This embodiment is an embodiment of a circuit for driving a semiconductor element (MOS-controlled diode) used in any of the above-described first to fifth embodiments. Fig. 17 is the circuit diagram of a drive circuit according to this embodiment.

This embodiment includes: a control circuit 20; IGBT drive circuits 21; drive circuits 22 for driving semiconductor apparatuses according to the first to fifth embodiments; an upper arm IGBT 23; a lower arm IGBT 24; a semiconductor apparatus 25 that is described in any of the above-described first to fifth embodiments and applied to the upper arm; a semiconductor apparatus 26 that is described in any of the above-described first to fifth embodiments and applied to the lower arm; and a current detector 30. Circuit signs used for the semiconductor apparatuses 25 and 26 respectively represent the resistor values of diodes each of which is controlled by the relevant gate electrode, and these circuit signs are devised by the inventors and others for the purpose of convenience, and they are not common signs.

In the present invention, it has been required so far for the gate voltage to be changed just before recovery. However, because the recovery is a phenomenon brought about along with the turnon of the relevant IGBT, the diode itself cannot know when it starts to recover. In other words, if attention is focused only on the diode, it is difficult to change the gate voltage of the diode just before the recovery of the diode.

Therefore, it was considered whether a positive voltage could be applied to the gate electrode just before the recovery of the diode by sensing the timing of the recovery of the diode from the behavior of the inverter. The recovery of the diode occurs when the IGBT of the counterpart arm (the counterpart arm is the upper arm for the lower arm and the lower arm for the upper arm) turns on. Therefore, if the gate of the IGBT and a diode of the counterpart arm according to the first embodiment are controlled using the same control circuit 20, it becomes possible to change the gate voltage of the diode of the counterpart arm from the control circuit just before the IGBT turns on (that is, just before the diode recovers).

Although the current detector 30 is a detector for detecting a current flowing through a diode, it is also possible to indirectly detect the current flowing through the diode by detecting the relevant IGBT current. Furthermore, it is also possible to estimate the diode current by detecting the motor current. Which of the gate drive sequence in the case of the rated current and the gate drive sequence in the case of a small current should be selected is determined in accordance with the collector current detected by the current detector 30 by the control circuit 20.

As described above, according to this embodiment, the losses and the vibrations (equivalent to noises) can be reduced by detecting a diode current, and therefore the streamlining, downsizing, and cost reduction of a semiconductor apparatus and a power conversion apparatus using the same can be realized.

### Ninth Embodiment

Hereinafter, a ninth embodiment of the present invention (a power conversion apparatus to which diodes according to the present invention are applied) will be explained.

The feature of this embodiment is the fact that diodes explained in the first to the fifth embodiments are applied to flywheel diodes 600. By applying diodes explained in the first to the fifth embodiments to diodes used in the inverter apparatus shown in Fig. 18, the losses in the diodes are reduced, which makes it possible to realize the reduction of the losses and downsizing of the inverter.

### Tenth Embodiment

Hereinafter, a tenth embodiment of the present invention (a power conversion apparatus to which IGBTs according to the present invention are applied) will be explained.

The feature of this embodiment is the fact that IGBTs explained in the sixth and the seventh embodiments are applied to the IGBTs 700. By applying the IGBTs explained in the sixth and the seventh embodiments to the IGBTs used in the inverter apparatus shown in Fig. 18, the losses in the diodes are reduced, which makes it possible to realize the reduction of the losses and downsizing of the inverter.

Here, the configuration of the inverter apparatus shown in Fig. 18 is an example, and an apparatus, which has the same number of serial-connected combinations, each of which includes a switching element and a diode reversely connected, as the number of the phases of an alternating current output, also has the same advantageous effect.

In addition, in the above embodiments, the descriptions have been made about inverters that convert a DC current to an AC current, but the present invention is not limited to inverters, and it will be obvious that converters that convert an AC current to a DC current can obtain similar advantageous effects.

### Reference Signs List

- 1···: n⁻ Type Drift Layer,
- 3···: p Type Channel Layer,
- 6···: n Type Cathode Layer,
- 8···: Gate Electrode,
- 9···: Gate Insulating Film,
- 10···: Anode Electrode,
- 11···: Cathode Electrode,
- 12···: Insulating Film,
- 13···: p⁺ Type Cathode Layer,
- 20···: Control Circuit,
- 21···: IGBT Drive Circuit,
- 22···: Diode Drive Circuit,
- 23···: Upper Arm IGBT,
- 24···: Lower Arm IGBT,
- 25···: Upper Arm Diode,
- 26···: Lower Arm Diode,
- 30···: Current Detector,
- 40···: Emitter Electrode,
- 41···: Collector Electrode,
- 42···: p Type Channel Layer,
- 43···: Gate Electrode (IGBT),
- 44···: n⁺ Type Emitter Layer,
- 600···: Flywheel Diode,
- 700···: IGBT,
- 800···: Gate Circuit,
- 900···: Positive Electric Power Supply Terminal,
- 901···: Negative Electric Power Supply Terminal,
- 910···: U-phase,
- 911···: V-phase,
- 912···: W-phase,
- 950···: Motor,
- 960···: Electric Power Supply.

## Claims

1. A semiconductor element drive apparatus for driving a semiconductor element that includes: a first conductivity type first semiconductor layer (n⁻ type drift layer); a second conductivity type second semiconductor layer (p type anode layer) that is adjacent to the first semiconductor layer and is exposed on one main surface (anode side); a first conductivity type third semiconductor layer (n type cathode layer) adjacent to the first semiconductor layer, the third semiconductor layer being exposed on the other main surface (cathode side) and having an impurity concentration higher than that of the first semiconductor layer (n⁻ type drift layer); and an insulating gate on the other main surface (cathode side), the semiconductor element drive apparatus comprising a section for detecting an anode current,
wherein the semiconductor element drive apparatus switches the insulating gate at a positive voltage to at a negative voltage just before recovery when the anode current is large, and holds the insulating gate at the positive voltage when the anode current is small.

2. A semiconductor element drive apparatus for driving a semiconductor element that includes: a first conductivity type first semiconductor layer (n⁻ type drift layer); a second conductivity type second semiconductor layer (p type anode layer) that is adjacent to the first semiconductor layer and is exposed on one main surface (anode side); a first conductivity type third semiconductor layer (n type cathode layer) adjacent to the first semiconductor layer, the third semiconductor layer being exposed on the other main surface (cathode side) and having an impurity concentration higher than that of the first semiconductor layer (n⁻ type drift layer); an insulating gate that penetrates the third semiconductor layer (n type cathode layer) and reaches the first semiconductor layer (n⁻ type drift layer); a second conductivity type fourth semiconductor layer (p⁺ type cathode layer) that is disposed between neighboring insulating gates while being in touch with the insulating gate in its own layer and exposed on the other main surface (cathode side); and an electrode (cathode electrode) that is electrically connected to the third semiconductor layer and the fourth semiconductor layer, the semiconductor element drive apparatus comprising a section for detecting an anode current,
wherein the semiconductor element drive apparatus switches the insulating gate at a positive voltage to at a negative voltage just before recovery when the anode current is large, and holds the insulating gate at the positive voltage when the anode current is small.

3. A semiconductor element drive apparatus for driving a semiconductor element that includes: a first conductivity type first semiconductor layer (n⁻ type drift layer); a second conductivity type second semiconductor layer (p type anode layer) that is adjacent to the first semiconductor layer and is exposed on one main surface (anode side); a first conductivity type third semiconductor layer (n type cathode layer) adjacent to the first semiconductor layer, the third semiconductor layer being exposed on the other main surface (cathode side) and having an impurity concentration higher than that of the first semiconductor layer (n⁻ type drift layer); an insulating gate that penetrates the third semiconductor layer (n type cathode layer) and reaches the first semiconductor layer (n⁻ type drift layer); and an electrode (cathode electrode) that is electrically connected to the third semiconductor layer, the semiconductor element drive apparatus comprising a section for detecting an anode current,
wherein the semiconductor element drive apparatus switches the insulating gate at a positive voltage to at a negative voltage just before recovery when the anode current is large, and holds the insulating gate at the positive voltage when the anode current is small.

4. A semiconductor element drive apparatus for driving a semiconductor element that includes: a first conductivity type first semiconductor layer (n⁻ type drift layer); a second conductivity type second semiconductor layer (p type anode layer) that is adjacent to the first semiconductor layer and is exposed on one main surface (anode side); a first conductivity type third semiconductor layer (n type cathode layer) adjacent to the first semiconductor layer, the third semiconductor layer being exposed on the other main surface (cathode side) and having an impurity concentration higher than that of the first semiconductor layer (n⁻ type drift layer); a second conductivity type fourth semiconductor layer (p⁺ type cathode layer) that is exposed on the other main surface (cathode side); an insulating gate in touch with the first semiconductor layer (n⁻ type drift layer); the insulating gate in touch with the third semiconductor layer (n type cathode layer); the insulating gate in touch with the fourth semiconductor layer (p⁺ type cathode layer); and an electrode (cathode electrode) that is electrically connected to the third semiconductor layer and the fourth semiconductor layer, the semiconductor element drive apparatus comprising a section for detecting an anode current,
wherein the semiconductor element drive apparatus switches the insulating gate at a positive voltage to at a negative voltage just before recovery when the anode current is large, and holds the insulating gate at the positive voltage when the anode current is small.

5. A semiconductor element drive apparatus for driving a semiconductor element that includes: a first conductivity type first semiconductor layer (n⁻ type drift layer); a second conductivity type second semiconductor layer (p type anode layer) that is adjacent to the first semiconductor layer and is exposed on one main surface (anode side); a first conductivity type third semiconductor layer (n type cathode layer) adjacent to the first semiconductor layer, the third semiconductor layer being exposed on the other main surface (cathode side) and having an impurity concentration higher than that of the first semiconductor layer (n⁻ type drift layer); an insulating gate in touch with the first semiconductor layer (n⁻ type drift layer); the insulating gate in touch with the third semiconductor layer (n type cathode layer); and an electrode (cathode electrode) that is electrically connected to the third semiconductor layer, the semiconductor element drive apparatus comprising a section for detecting an anode current,
wherein the semiconductor element drive apparatus switches the insulating gate at a positive voltage to at a negative voltage just before recovery when the anode current is large, and holds the insulating gate at the positive voltage when the anode current is small.

6. The semiconductor element drive apparatus for driving a semiconductor element according to any of claims 1 to 5, wherein a threshold for judging whether the anode current is large or small is set to a half of or smaller than the rated current.

7. A semiconductor element drive apparatus for driving a semiconductor element that includes: a first conductivity type first semiconductor layer (n⁻ type drift layer); a second conductivity type second semiconductor layer (p type anode layer) that is adjacent to the first semiconductor layer and is exposed on one main surface; a first conductivity type third semiconductor layer (n type cathode layer) adjacent to the first semiconductor layer, the third semiconductor layer being exposed on the one main surface and having an impurity concentration higher than that of the first semiconductor layer (n⁻ type drift layer); and an insulating gate adjacent to the third semiconductor layer (n type cathode layer), the semiconductor element drive apparatus comprising a section for detecting an anode current,
wherein the semiconductor element drive apparatus switches the insulating gate at a positive voltage to at a negative voltage just before recovery when the anode current is large, and holds the insulating gate at the positive voltage when the anode current is small.

8. A semiconductor element drive apparatus comprising:
a pair of DC terminals, wherein a composition of two parallel circuits that are serial-connected between the pair of DC terminals, each of the two parallel circuits including a switching element, and a reversely-connected diode is connected, the interconnection point between the parallel circuits is connected to an AC terminal, and a semiconductor element described in any of claim 1 to claim 7 is used as the diode;
a first switching element and a second switching element that are serial-connected as described above; a first diode parallel-connected to the first switching element;
a second diode parallel-connected to the second switching element;
a current detector for detecting the anode currents of the diodes; and
a control circuit for driving the gates of the first and second switching elements and the gates of the first and second switching diodes respectively.

9. A semiconductor element drive apparatus for driving a semiconductor element that includes: a first conductivity type first semiconductor layer (n⁻ type drift layer); a second conductivity type second semiconductor layer (p type channel layer) that is adjacent to the first semiconductor layer and is exposed on one main surface (emitter side); a first insulating gate that is fabricated on the one main surface (emitter side) and used for turning a main current (collector current) on and off; a first conductivity type fifth semiconductor layer (n⁺ type emitter layer) that is disposed between neighboring first insulating gates while being in touch with the insulating gates in its own layer and exposed on the one main surface (emitter side); an electrode (emitter electrode) that is electrically connected to the second semiconductor layer and the fifth semiconductor layer; a first conductivity type third semiconductor layer (n type collector layer) adjacent to the first semiconductor layer, the third semiconductor layer being exposed on the other main surface (collector side) and having an impurity concentration higher than that of the first semiconductor layer (n⁻ type drift layer); and a second insulating gate fabricated on the other main surface (collector side), the semiconductor element drive apparatus comprising a section for detecting an collector current,
wherein the semiconductor element drive apparatus switches the second insulating gate at a negative voltage to at a positive voltage just before turnoff when the collector current is large, and holds the insulating gate at the negative voltage when the collector current is small.

10. A power conversion apparatus comprising:
a pair of DC terminals;
AC terminals the number of which is the same as that of the phases of an AC current;
compositions each of which includes two parallel circuits that are serial-connected between the pair of DC terminals, each of the two parallel circuits including a switching element and a reversely-connected diode; and
power conversion units the number of which is the same as the number of phases of an AC current in which the interconnection points of the parallel circuits are connected to different AC terminals respectively,
wherein apparatuses for driving the diodes are semiconductor element drive apparatuses according to any of claim 1 to claim 8.

11. A power conversion apparatus comprising:
a pair of DC terminals;
compositions each of which includes two parallel circuits that are serial-connected between the pair of DC terminals, each of the two parallel circuits including a switching element and a reversely-connected diode; and
power conversion units the number of which is the same as the number of phases of an AC current in which the interconnection points of the parallel circuits are connected to different AC terminals respectively,
wherein apparatuses for driving the switching elements are drive apparatuses according to claim 9.
